# EUROPEAN PATENT APPLICATION

(11) **EP 2 955 001 A1**
(43) Date of publication of application: **16.12.2015**
(21) Application number: 14748558.5
(22) Date of filing: 04.02.2014
(51) Int. Cl.: B29C 59/04, B29C 33/10, B29C 33/42, H01L 21/027

(54) **ROLLER DEVICE USING SUCTION ROLLER, AND PRODUCTION METHOD FOR MEMBER HAVING UNEVEN STRUCTURE**

(30) Priority: 08.02.2013 JP 2013023239
(71) Applicant: JX Nippon Oil & Energy Corporation, Chiyoda-ku Tokyo 100-8162 (JP)
(72) Inventor: TAKAHASHI, Madoka, Tokyo 100-8162 (JP); TORIYAMA, Shigetaka, Tokyo 100-8162 (JP)
(74) Representative: Kuhnen & Wacker
(86) International application number: PCT/JP2014/052477
(87) International publication number: WO 2014/123093

(57) **Abstract**

A roll apparatus 300 includes a suction roll 25, a suction mechanism 65, and a gas-permeable member 81. The suction roll 25 is rotatable and has an outer circumferential surface 25a and an inside defined by the outer circumferential surface 25a. The suction mechanism 65 generates a suction force toward the inside from an outside of the suction roll 25. The gas-permeable member 81 covers the outer circumferential surface 25a of the suction roll 25. The gas-permeable member 81 and the suction roll 25 allow water vapor to be uniformly extracted from an object to be processed while the object to be processed is pressed by means of the gas-permeable member 81. The roll apparatus 300 of the present invention is capable of producing a member having a concave-convex structure to be used for diffracting or scattering light at a high yield and high throughput.

## Description

### Technical Field

The present invention relates to a roll apparatus (roller device) using a suction roll (suction roller) and a method for producing a member having a concave-convex structure (un-even structure or concave and convex structure).

### Background Art

The lithography method is known as a method for forming a fine pattern (minute pattern) such as a semiconductor integrated circuit. The resolution of a pattern formed by the lithography method depends on the wavelength of a light source, the numerical aperture of an optical system, etc., and a shorter wavelength light source is desired so as to respond to the demand for miniaturized devices in the recent years. Any short wavelength light source is, however, expensive and is not easily developed, and any optical material allowing such short wavelength light passing therethrough needs to be developed, as well. Further, a large sized optical element is required for producing a pattern with a large area by means of the conventional lithography method, which is difficult both technically and economically. Therefore, a new method for forming a desired pattern having a large area has been considered.

The nano-imprint method is known as a method for forming a fine pattern without using any conventional lithography apparatus. The nano-imprint method is a technology capable of transferring a pattern in nano-meter order by sandwiching a resin between a mold (die) and a substrate, and is expected to be practiced not only in the field of semiconductor device but also in many fields such as optical members like organic EL element, LED, etc.; MEMS; biochips; and the like.

As the nanoimprint method using a thermosetting material, there has been known a method such as that described in Patent Literature 1. That is, a substrate is coated with a resist film, the substrate is pressed with a mold having a flat plate shape, and then the resist film is cured using a heater. A nanoimprint molded product using an inorganic sol-gel material, in particular, has high heat resistance, and thus it is suitable for the process including a high temperature treatment. In addition to the pressing method using the flat-plate shaped mold, there has been known the roll press method, as described in Patent Literature 2, in which a pressing roll and a cylindrical master plate for duplication having a minute concave-convex pattern are used. In the case of using the sol-gel material, however, the amount of water and the drying time after the coating are required to be controlled precisely. This makes the mass-production difficult.

Meanwhile, Patent Literature 3 discloses that, when the pattern is transferred to the sol-gel material by the nanoimprint method, using a gas-permeable mold made of polydimethylsiloxane (PDMS) can facilitate the curing of the sol-gel material even during the time in which the sol-gel material is adhered to (stuck onto, or brought into tight contact with) the mold. Since water and the solvent in a sol-gel layer can diffuse in the mold made of PDMS, a chemical reaction of the sol-gel material and the evaporation of the solvent and water generated by the chemical reaction can proceed, therefore the sol-gel material can be cured (turn into a gel) even during the time in which the sol-gel material is adhered to the mold.

### Citation List

### Patent Literature

PATENT LITERATURE 1: Japanese Patent Application Laid-open No. 2008-049544
PATENT LITERATURE 2: Japanese Patent Application Laid-open No. 2010-269480
PATENT LITERATURE 3: Japanese Patent Application Laid-open No. 2008-068611

### Summary of Invention

### Technical Problem

An object of the present invention is to provide a novel production apparatus and production method capable of mass-producing a member having a fine or minute concave-convex structure at a high yield.

### Solution to the Problem

According to a first aspect of the present invention, there is provided a roll apparatus, including: a suction roll being rotatable and having an outer circumferential surface and an inside defined by the outer circumferential surface; a suction mechanism configured to generate a suction force toward the inside from an outside of the suction roll; and a gas-permeable member covering the outer circumference surface of the suction roll.

In the roll apparatus, the gas-permeable member may be made of silicone rubber.

In the roll apparatus, a concave-convex pattern (concave and convex pattern) may be formed on a surface of the gas-permeable member.

In the roll apparatus, the concave-convex pattern of the gas-permeable member may be a pattern by which a sol-gel material is patterned.

In the roll apparatus, the concave-convex pattern of the gas-permeable member may be an irregular concave-convex pattern in which a standard deviation of depth of concavities and convexities is in a range of 10 nm to 100 nm and an average pitch of the concavities and convexities is in a range of 100 nm to 1500 nm.

A Fourier-transformed image of the concave-convex pattern of the gas-permeable member may show an annular pattern.

The roll apparatus may further include a heating means configured to heat the suction roll.

In the roll apparatus, the gas-permeable member may have a water vapor transmission rate of not less than 1 x 10⁻⁶ [(mL·cm) / (cm²·s·cmHg)].

In the roll apparatus, the gas-permeable member may have a thickness ranging from 10 µm to 1 cm.

In the roll apparatus, the gas-permeable member may have surface energy of not more than 25 mN/m.

The roll apparatus may further include a driving unit configured to rotate the suction roll around a rotational shaft (axis) thereof. In the roll apparatus, the outer circumferential surface of the suction roll may be made of a porous body. The porous body may be ceramic. In the roll apparatus, the outer circumferential surface of the suction roll may have a mesh-like form in which suction holes are provided uniformly at a regular interval.

According to a second aspect of the present invention, there is provided a method for producing a member having a concave-convex structure by use of the roll apparatus as defined in the first aspect, the method including: a step of forming a coating film on a substrate; a step of transferring the concave-convex pattern of the gas-permeable member onto the coating film by adhering the concave-convex pattern of the gas-permeable member to the coating film while rotating the suction roll; and a step of curing the coating film. The member having the concave-convex structure may be, for example, an optical substrate.

In the method for producing the member having the concave-convex structure, the concave-convex pattern may be transferred to the coating film while the suction force is being generated in the suction roll.

In the method for producing the member having the concave-convex structure, the coating film may be made of a sol-gel material.

In the method for producing the member having the concave-convex structure, the coating film may be adhered to the concave-convex pattern of the gas-permeable member while being heated.

According to a third aspect of the present invention, there is provided a method for producing an organic EL element (organic Electro-Luminescence element or organic light emitting diode), including: preparing a diffraction grating substrate having a concave-convex surface (concave and convex surface) as the member having the concave-convex structure, by the method for producing the member having the concave-convex structure as defined in the second aspect; and successively stacking a transparent electrode, an organic layer, and a metal electrode on the concave-convex surface of the diffraction grating substrate.

### Advantageous Effects of Invention

The roll apparatus of the present invention includes the gas-permeable member and the suction roll. Thus, water vapor can be extracted uniformly from an object to be processed while the object to be processed is pressed, biased or urged by the gas-permeable member. The use of the roll apparatus of the present invention makes it possible to perform the pattern formation of the coating film precisely and reliably and to produce the member having the concave-convex structure, such as the optical substrate, with high throughput.

### Brief Description of Drawings

Fig. 1 is a flow chart illustrating a method for producing a member having a concave-convex structure of the present invention.
Figs. 2(A) to 2(C) schematically depict steps for producing a gas-permeable member, which is used for a method for producing an optical substrate in an embodiment of the present invention.
Fig. 3 is a schematic perspective view of a roll apparatus in the embodiment of the present invention.
Fig. 4 is a cross-sectional view schematically depicting the roll apparatus of Fig. 3 as viewed from the A-A direction in Fig. 3.
Fig. 5 is a conceptual view illustrating a transfer process using the gas-permeable member.
Fig. 6 is a conceptual view of an apparatus for producing the optical substrate in the embodiment of the present invention.
Fig. 7 is a conceptual view of an apparatus for producing the optical substrate in a modified embodiment of present invention in which a ring-like or looped gas-permeable member is disposed to bridge between or extend over two or more rolls instead of providing the transfer roll.
Fig. 8 depicts a cross-sectional structure of an organic EL element.

### Description of Embodiments

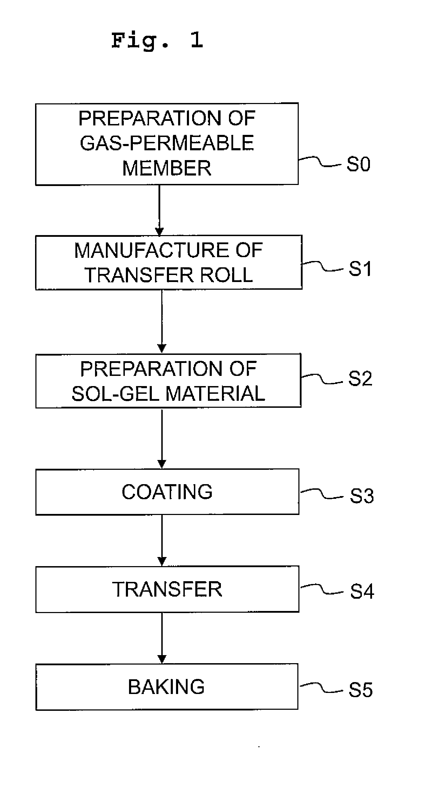

An explanation about embodiments of a method and an apparatus for producing a member having a concave-convex pattern or concave-convex structure of the present invention will be made below with reference to the drawings. The following explanation will be made by citing a sol-gel material as the material of a coating film coating a substrate. The method for producing the member having the concave-convex pattern or concave-convex structure according to the present invention mainly includes, as depicted in Fig. 1, a step S0 of preparing a gas-permeable member; a step S1 of manufacturing a transfer roll with the gas-permeable member; a preparation step S2 of preparing a sol-gel material; a coating step S3 of coating a substrate with the prepared sol-gel material; a transfer step S4 of curing the coating film while adhering the coating film to the gas-permeable member of the transfer roll; and a baking step S5 of baking the coating film. The steps will be successively explained as follows. The following explanation will be made by citing an optical substrate having the concave-convex pattern as the member having the concave-convex pattern or concave-convex structure.

### [Step of preparing gas-permeable member]

In the method and apparatus for producing the optical substrate of this embodiment, the gas-permeable member to be used as a mold is flexible and has a concave-convex transfer pattern on the surface thereof. The gas-permeable member can be manufactured by a method for manufacturing the gas-permeable member as described later on. The gas-permeable member is made of rubber material. Silicone rubber or a mixture or copolymer of silicone rubber and any other material is particularly preferable. Those usable as the silicone rubber include, for example, polyorganosiloxane, cross-linking type polyorganosiloxane, a polyorganosiloxane/polycarbonate copolymer, a polyorganosiloxane/polyphenylene copolymer, a polyorganosiloxane/polystyrene copolymer, polytrimethyl-silylpropyne, and poly-4-methyl pentene. The silicone rubber is cheaper than other resin materials; has superior heat resistance, high heat conductivity, and elasticity; and is less likely to be deformed under a high temperature condition. Thus, the silicone rubber is suitable for the process for transferring concave-convex pattern under the high temperature condition. Further, since the silicone rubber material has high permeability of gas and water vapor, the solvent and water vapor of a material to be subjected to transfer can go through or permeate the silicone rubber material easily. It is preferred that the water vapor transmission rate of the gas-permeable member be not less than 1 x 10⁻⁶ [(mL·cm) / (cm²·s·cmHg)]. When the water vapor transmission rate of the gas-permeable member is less than the lower limit, it takes time to evaporate water and the solvent in the coating film during the transfer of the concave-convex pattern of the gas-permeable member to the coating film on the substrate. In such a case, the coating film fails to be cured or the curing is required to be performed over a long time. Further, it is preferred that the surface free energy of rubber material used for the gas-permeable member be not more than 25 mN/m. This results in a superior mold-releasing property during the transfer of the concave-convex pattern of the gas-permeable member to the coating film on the substrate, thereby making it possible to prevent any transfer failure.

The gas-permeable member may have, for example, a length in a range of 50 mm to 2000 mm, a width in a range of 50 mm to 3000 mm, and a thickness in a range of 10 µm to 1 cm. The size of the gas-permeable member can be set appropriately based on the size of the transfer roll, the size of the optical substrate to be mass-produced, the number of optical substrates (the number of lots) continuously produced in a single manufacturing or producing process, and the like. When the thickness of the gas-permeable member is less than the lower limit, the strength of the gas-permeable member might be insufficient. This could lead to the damage of the gas-permeable member during the handling of the gas-permeable member. When the thickness of the gas-permeable member exceeds the upper limit, it might be difficult to wind or roll up the mold in a roll shape and the water vapor permeability of the gas-permeable member might be insufficient. Further, a mold-release treatment may be performed on the surface of the concave-convex pattern as needed. The concave-convex pattern may be formed to have an arbitrary shape by an arbitrary method such as a BCP method, a BKL method, or a photolithography method as described later on.

The concave-convex pattern may be any pattern depending on the usage of the optical substrate as a finally obtained product. For example, the concave-convex pattern may be a micro lens array structure and a structure having the light scattering function, light diffracting function, etc. The concave-convex pattern, for example, may be an irregular concave-convex pattern in which pitches of concavities and convexities are non-uniform and the orientations of the concavities and convexities have no directionality. When the optical substrate is used, for example, for scattering or diffracting visible light, the average pitch of the concavities and convexities can be within a range of 100 nm to 1,500 nm, and more preferably within a range of 200 nm to 1,200 nm. When the average pitch of the concavities and convexities is less than the lower limit, the pitches are so small relative to the wavelengths of the visible light that the diffraction of light by the concavities and convexities is likely to be insufficient; on the other hand, when the average pitch exceeds the upper limit, the diffraction angle is so small that the functions as an optical element such as the diffracting grating are more likely to be lost. In a similar usage, the average value of depth distribution of the concavities and convexities is preferably in a range of 20 nm to 200 nm, and more preferably in a range of 30 nm to 150 nm. The standard deviation of the depth of the concavities and convexities is preferably in a range of 10 nm to 100 nm, and more preferably in a range of 15 nm to 75 nm.

Note that the term "average pitch of the concavities and convexities" means an average value of the pitch of concavities and convexities in a case of measuring the pitch of the concavities and convexities (spacing distance between adjacent convex portions or spacing distance between adjacent concave portions) in a surface on which the convexities and concavities are formed. Such an average value of the pitch of concavities and convexities is obtained as follows. Namely, a concavity and convexity analysis image is obtained by measuring the shape of the concavities and convexities on the surface by using a scanning probe microscope (for example, a scanning probe microscope manufactured by Hitachi High-Tech Science Corporation, under the product name of "E-sweep", etc.), under the following measurement conditions, then the distances between randomly selected concave portions or convex portions adjacent to each other are measured at not less than 100 points in the concavity and convexity analysis image, and then the average of the distances is calculated and is determined as the average value of the pitch of concavities and convexities.

The measurement conditions are as follows:
Measurement mode: cantilever intermittent contact mode
Material of the cantilever: silicon
Lever width of the cantilever: 40 µm
Diameter of tip of chip of the cantilever: 10 nm

Further, in the present application, the average value of the depth distribution of concavities and convexities and the standard deviation of the depth of concavities and convexities can be calculated by the following manner. Namely, a concavity and convexity analysis image is obtained by measuring the shape of the concavities and convexities on the surface by using a scanning probe microscope (for example, a scanning probe microscope manufactured by Hitachi High-Tech Science Corporation, under the product name of "E-sweep", etc.), in a randomly selected measurement region of 3 µm square (vertical: 3 µm, horizontal: 3 µm) or in a randomly selected measurement region of 10 µm square (vertical: 10 µm, horizontal: 10 µm) under the above-described condition. When doing so, data of height of concavities and convexities at not less than 16,384 points (vertical: 128 points x horizontal: 128 points) are obtained within the measurement region, each in nanometer scale. Note that although the number of measurement points is different depending on the kind and setting of the measuring device which is used, for example in a case of using the above-described scanning probe microscope manufactured by Hitachi High-Tech Science Corporation, under the product name of "E-sweep", it is possible to perform the measurement at measurement points of 65,536 points (vertical: 256 points x horizontal: 256 points; namely, the measurement in a resolution of 256 x 256 pixels) within the measurement region of 3 µm square. With respect to the height of concavities and convexities (unit: nm) measured in such a manner, at first, a measurement point "P" is determined, among all the measurement points, which is the highest from the surface of a transparent support substrate. Then, a plane which includes the measurement point P and which is parallel to the surface of the transparent support substrate is determined as a reference plane (horizontal plane), and a depth value from the reference plane (difference obtained by subtracting, from the value of height from the transparent support substrate at the measurement point P, the height from the transparent support substrate at each of the measurement points) is obtained as the data of depth of concavities and convexities. Note that such a depth data of the concavities and convexities can be obtained, for example, by performing automatic calculation with software in the measurement device (for example, the above-described scanning probe microscope manufactured by Hitachi High-Tech Science Corporation, under the product name of "E-sweep"), and the value obtained by the automatic calculation in such a manner can be utilized as the data of depth of concavities and convexities. After obtaining the data of depth of concavity and convexity at each of the measurement points in this manner, the values, which can be calculated by obtaining the arithmetic average value and the standard deviation of the obtained data of depth of concavity and convexity, are adopted as the average value of the depth distribution of concavities and convexities and the standard deviation of the depth of concavities and convexities. In this specification, the average pitch of concavities and convexities and the average value of the depth distribution of concavities and convexities can be obtained via the above-described measuring method, regardless of the material of the surface on which the concavities and convexities are formed.

The light(s) scattered and/or diffracted by such a concave-convex pattern is (are) a light having a wavelength in a relatively broad band, rather than a light having a single wavelength or a light having a wavelength in a narrow band, and the scattered and/or diffracted light(s) have no directivity, and travel(s) in various directions. Note that, however, the term "irregular concave-convex pattern" includes such a quasi-periodic structure in which a Fourier-transformed image, obtained by performing a two-dimensional fast Fourier-transform processing on a concavity and convexity analysis image obtained by analyzing a concave-convex shape on the surface, shows a circular or annular pattern, namely, such a quasi-periodic pattern in which, although the concavities and convexities have no particular orientation (directionality), the structure has the distribution of the pitches of concavities and convexities (the pitches of the concavities and convexities vary). Therefore, the substrate having such a quasi-periodic structure is suitable for a diffraction substrate used in a surface-emitting element etc., such as the organic EL element, a transparent conductive substrate of a solar cell, and the like, provided that the substrate has the concavities and convexities of which pitch distribution or pitch variability enables the substrate to diffract visible light.

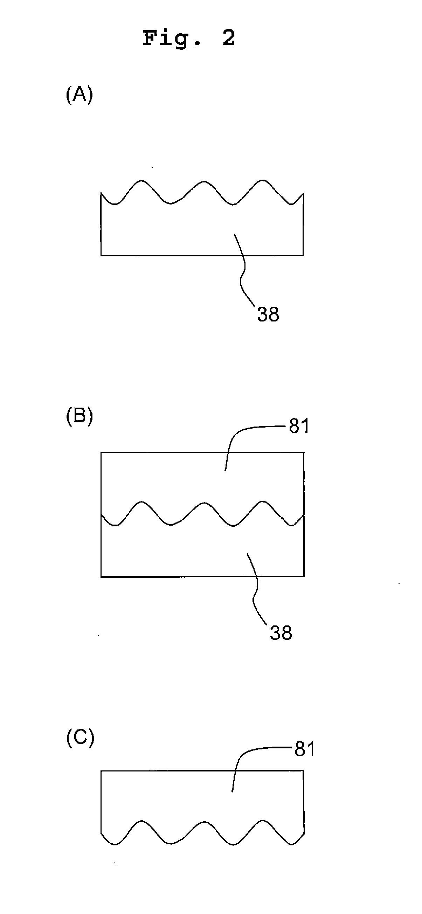

An explanation about an exemplary production method of the gas-permeable member used in the present invention will be made with reference to Figs. 2(A)-2(C).

A master mold 38 for forming the concave-convex pattern of the gas-permeable member is manufactured first. It is preferred that the concave-convex pattern of the master mold 38 be formed by a method of utilizing the self-organization or self-assembly (micro phase separation) of a block copolymer described in Japanese Patent Application No. 2011-006487(WO2012/096368A1) of the applicants of the present invention (hereinafter referred to as "BCP (Block Copolymer) method" as appropriate), a method of heating and cooling a vapor deposited film on a polymer film to form concavities and convexities of wrinkles on a surface of polymer, as disclosed in International Publication No. WO2011/007878 A1 of the applicants of the present invention (hereinafter referred to as "BKL (Buckling) method" as appropriate), etc. The photolithography method may be utilized instead of the BCP and BKL methods. In addition to the above methods, it is possible to manufacture the concave-convex pattern of the master mold 38 by, for example, microfabrication or fine-processing methods including a cutting (cutting and processing) or machining method, an electron-beam direct imaging method, a particle beam processing method, a scanning probe processing method, and a fine-processing method using the self-organization or self-assembly of fine particles, etc. When the pattern is formed by the BCP method, although the pattern made of any material can be used, the material is preferably a block copolymer composed of a combination of two selected from the group consisting of a styrene-based polymer such as polystyren; polyalkyl methacrylate such as polymethyl methacrylate; polyethylene oxide; polybutadiene; polyisoprene; polyvinylpyridine; and polylactic acid.

The pitches and heights of concavities and convexities of the pattern of the master mold 38 are arbitrary. However, for example, when the pattern is used as the diffraction grating scattering or diffracting light in a visible region, the average pitch of the concavities and convexities is preferably in a range of 100 nm to 1,500 nm, more preferably in a range of 200 nm to 1,200 nm. When the average pitch of the concavities and convexities is less than the lower limit, the pitches are so small relative to wavelengths of the visible light that the diffraction of the light by the concavities and convexities is less likely to occur. When the average pitch exceeds the upper limit, the diffraction angle is so small that functions as an optical element such as the diffraction grating are more likely to be lost. The average value of the depth distribution of the concavities and convexities is preferably in a range of 20 nm to 200 nm, and more preferably in a range of 30 nm to 150 nm. When the average value of the depth distribution of concavities and convexities is less than the lower limit, the height is so short relative to the wavelengths of the visible light that the required diffraction is less likely to occur. On the other hand, when the average value exceeds the upper limit, the intensity of diffracted light becomes non-uniform, which in turn results in the following tendency. Namely, when such a concave-convex pattern is used, for example, as an optical element for the light extraction of an organic EL element, the electric field distribution in an EL layer becomes non-uniform, thereby causing the electric field to concentrate on a certain position or area in the EL layer and thus causing any leak current to be easily generated, and/or shortening the service life of the optical element. The standard deviation of the depth of convexities and concavities is preferably within a range of 10 nm to 100 nm, and more preferably within a range of 15 nm to 75 nm. When the standard deviation of the depth of the concavities and convexities is less than the lower limit, the height is so short relative to the wavelengths of the visible light that the required diffraction is less likely to occur. On the other hand, when the standard deviation exceeds the upper limit, the intensity of diffracted light becomes non-uniform, which in turn results in the following tendency. Namely, when such a concave-convex pattern is used, for example, as an optical element for the light extraction of an organic EL element, the electric field distribution in an EL layer becomes non-uniform, thereby causing the electric field to concentrate on a certain position or area in the EL layer and thus causing any leak current to be easily generated, and/or shortening the service life of the optical element.

After the master mold 38 is formed by the BCP method, the BKL method, or the like (Fig. 2(A)), a gas-permeable member 81 to which the pattern of the master mold 38 has been transferred is formed as follows. At first, a base resin (main agent), which is the raw material of rubber material, is mixed with a curing agent, and the mixture is stirred or agitated for 10 minutes. This mixture (hereinafter also referred to as "gas-permeable member material" as appropriate) may be diluted with a solvent such as toluene. After stirred, the gas-permeable member material is subjected to degasification under reduced pressure. Then, the degassed gas-permeable member material is applied on the concave-convex pattern of the master mold 38 manufactured in advance (Fig. 2(B)). As the coating method, it is possible to use any coating method such as a cast method, a doctor blade method, or a spin coating method. Subsequently, the gas-permeable member material coating the concave-convex pattern is heated to be cured. The convex-concave pattern of the master mold 38 is transferred and fixed to the gas-permeable member material upon the curing of the gas-permeable member material. The heating temperature is preferably in a range of room temperature to 50°C. The heating can be performed by any means including, for example, an oven and a hot plate.

The cured gas-permeable member material is released or peeled off from the master mold 38 to obtain the gas-permeable member 81 (Fig. 2(C)). The gas-permeable member 81 can be manually released from the master mold 38 from the edge or end portion of the master mold 38. Alternatively, the gas-permeable member 81 can be released by fixing one end portion of the gas-permeable member 81 to the outer circumferential surface of a suction roll described later on by use of an adhesive agent, a tape, or the like, and then rolling up the gas-permeable member 81 by the aid of the rotation of the suction roll.

### [Step of manufacturing transfer roll]

Next, a transfer roll 50 is manufactured by using the released gas-permeable member 81. The transfer roll 50 is formed of a suction roll 25 and the gas-permeable member 81 wound around the outer circumferential surface of the suction roll 25.

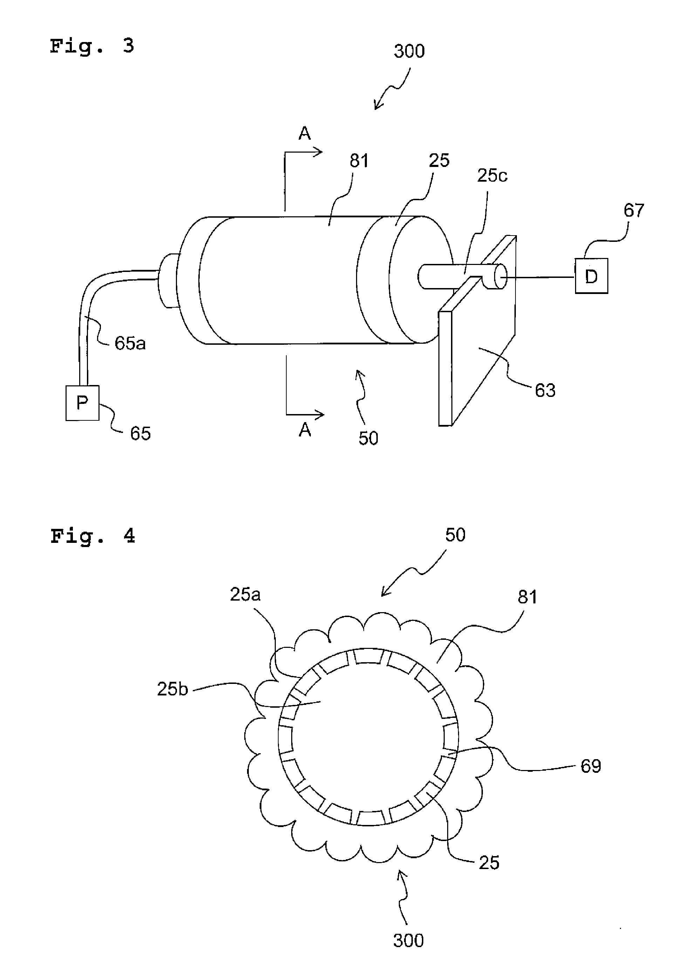

The suction roll 25 is a roll having outer circumferential surface 25a (see Fig. 4) through which suction force toward an inside 25b from an outside of the suction roll 25 is exerted. The suction roll 25 has, for example, a cylindrical roll body. A large number of suction holes 69 (see Fig. 4) are provided in the outer circumferential surface 25a of the cylindrical roll body. The suction holes 69 penetrate through the peripheral wall of the cylindrical roll body. The suction holes 69 can be provided by using a porous body, such as ceramic, as the material for the outer circumferential surface 25a of the suction roll 25. In this case, the hole diameter of the porous body is preferably in a range of 0.1 µm to 20 µm. The suction holes 69 may be formed by making the outer circumferential surface 25a of the suction roll 25 have a mesh-like form by use of a punching metal or the like. Here, it is preferred that the diameter of the suction hole be in a range of 0.5 mm to 2.0 mm; that the pitch between holes be in a range of 1 mm to 3 mm; and that the suction holes 69 be uniformly provided at a regular interval. Further, the suction holes 69 may be formed to be circular, elliptic, a diamond or rhombus-shaped, slit-shaped, or the like. The suction roll 25 is capable of suctioning the gas and/or object on the outside of the roll through the suction holes 69 toward the inside of the roll. The suction roll 25 may include a heater.

The manufactured gas-permeable member 81 is put on or around the outer circumferential surface 25a of the suction roll 25 (see Fig. 4) and then fixed thereto to obtain the transfer roll 50. The gas-permeable member 81 may be fixed to the outer circumferential surface 25a of the suction roll 25 by use of the adhesive agent, the tape, or adhesive force of the gas-permeable member 81 itself. Alternatively, the gas-permeable member 81 may be sucked and fixed to the outer circumferential surface 25a of the suction roll 25 by the aid of the suction force coming from a large number of suction holes 69 formed in the outer circumferential surface 25a of the suction roll 25. It is not required to cover the entire outer circumferential surface 25a of the suction roll 25 with the gas-permeable member 81. A part of the outer circumferential surface 25a of the suction roll 25 in the circumferential direction or a part of the outer circumferential surface 25a of the suction roll 25 in the axis direction (as depicted in Fig. 3) may be covered with the gas-permeable member 81 depending on the intended use.

The transfer roll 50 manufactured by the above method can be used in a roll apparatus 300 as depicted in Figs. 3 and 4. The roll apparatus 300 includes the transfer roll 50, a suction mechanism 65, and a drive unit 67. As the suction mechanism 65, it is possible to use, for example, a suction pump which is connected to the bottom surface or upper surface of the suction roll 25 of the transfer roll 50 via a tube 65a. The drive unit 67 may be, for example, a motor which rotates a shaft 25c of the suction roll 25 of the transfer roll 50 via a belt or gear. It is preferred that the pressure in an interior (inside) 25b of the suction roll 25 be reduced to, for example, 10⁵ Pa or less, particularly preferably 10³ Pa or less, by use of the suction mechanism 65. The shaft 25c of the suction roll 25 is rotatably installed to a support base 63, thereby the transfer roll 50 is rotatably supported. The transfer roll 50 can be rotated by the drive unit 67 around the shaft 25c of the suction roll 25 as a rotational shaft (rotational axis).

The step S0 of preparing the gas-permeable member and the step S1 of manufacturing the transfer roll may be performed at any time, provided that they are performed before the transfer step S4 which will be described later. The steps S0 and S1 may be performed before the step S2 of preparing the sol-gel material or after the step S2. Or, the steps S1 and S2 may be performed in parallel with the step S2 of preparing the sol-gel material.

### <Sol-gel material preparation step>

In the method for producing the optical substrate of this embodiment, the sol-gel material (sol) is prepared, by the sol-gel method, so as to form the coating film to which the pattern is to be transferred (step S2 of Fig. 1). For example, when silica is synthesized on a substrate by the sol-gel method, a sol-gel material of metal alkoxide (silica precursor) is prepared. The silica precursor is exemplified by metal alkoxides including, for example, tetraalkoxide monomers such as tetramethoxysilane (TMOS), tetraethoxysilane (TEOS), tetra-i-propoxysilane, tetra-n-propoxysilane, tetra-i-butoxysilane, tetra-n-butoxysilane, tetra-sec-butoxysilane, and tetra-t-butoxysilane; trialkoxide monomers such as methyl trimethoxysilane, ethyl trimethoxysilane, propyl trimethoxysilane, isopropyl trimethoxysilane, phenyl trimethoxysilane, methyl triethoxysilane (MTES), ethyl triethoxysilane, propyl triethoxysilane, isopropyl triethoxysilane, phenyl triethoxysilane, methyl tripropoxysilane, ethyl tripropoxysilane, propyl tripropoxysilane, isopropyl tripropoxysilane, phenyl tripropoxysilane, methyl triisopropoxysilane, ethyl triisopropoxysilane, propyl triisopropoxysilane, isopropyl triisopropoxysilane, phenyl triisopropoxysilane; dialkoxide monomers such as dimethyl dimethoxysilane, dimethyl diethoxysilane, dimethyl dipropoxysilane, dimethyl diisopropoxysilane, dimethyl di-n-butoxysilane, dimethyl di-i-butoxysilane, dimethyl di-sec-butoxysilane, dimethyl di-t-butoxysilane, diethyl dimethoxysilane, diethyl diethoxysilane, diethyl dipropoxysilane, diethyl diisopropoxysilane, diethyl di-n-butoxysilane, diethyl di-i-butoxysilane, diethyl di-sec-butoxysilane, dipropyl di-t-butoxysilane, dipropyl dimethoxysilane, dipropyl diethoxysilane, dipropyl dipropoxysilane, dipropyl diisopropoxysilane, dipropyl di-n-butoxysilane, dipropyl di-i-butoxysilane, dipropyl di-sec-butoxysilane, dipropyl di-t-butoxysilane, diisopropyl dimethoxysilane, diisopropyl diethoxysilane, diisopropyl dipropoxysilane, diisopropyl diisopropoxysilane, diisopropyl di-n-butoxysilane, diisopropyl di-i-butoxysilane, diisopropyl di-sec-butoxysilane, diisopropyl di-t-butoxysilane, diphenyl dimethoxysilane, diphenyl diethoxysilane, diphenyl dipropoxysilane, diphenyl diisopropoxysilane, diphenyl di-n-butoxysilane, diphenyl di-i-butoxysilane, diphenyl di-sec-butoxysilane, diphenyl di-t-butoxysilane; a polymer obtained by polymerizing the above monomers in small amounts; and a composite material characterized in that functional group and/or polymer is/are introduced into a part of the above material. Furthermore, the silica precursor is exemplified, for example, by metal acetylacetonate, metal carboxylate, oxychloride, chloride, and mixtures thereof. However, the silica precursor is not limited to these. Moreover, examples of the metal species other than Si include Ti, Sn, Al, Zn, Zr, In and mixtures thereof, but the examples of the metal species are not limited to these. It is also possible to use any appropriate mixture of precursors of the oxides of the above metals.

When a mixture of TEOS and MTES is used, the mixture ratio thereof can be, for example, 1:1 in a molar ratio. The sol-gel material produces amorphous silica by being subjected to the hydrolysis and polycondensation reaction. An acid such as hydrochloric acid or an alkali such as ammonia is added in order to adjust the pH of the solution as a synthesis condition. The pH is preferably not more than 4 or not less than 10. Water may be added to perform the hydrolysis. The amount of water to be added can be not less than 1.5 times, with respect to the amount of metal alkoxide species, in the molar ratio. It is possible to use, as the sol-gel material, a material other than the silica. For example, a titanium-based material, a material based on indium tin oxide (ITO), Al₂O₃, ZrO₂, ZnO, etc. may be used.

The solvent for the sol-gel material is exemplified, for example, by alcohols such as methanol, ethanol, isopropyl alcohol (IPA), and butanol; aliphatic hydrocarbons such as hexane, heptane, octane, decane, and cyclohexane; aromatic hydrocarbons such as benzene, toluene, xylene, and mesitylene; ethers such as diethyl ether, tetrahydrofuran, and dioxane; ketones such as acetone, methyl ethyl ketone, isophorone, and cyclohexanone; ether alcohols such as butoxyethyl ether, hexyloxyethyl alcohol, methoxy-2-propanol, and benzyloxyethanol; glycols such as ethylene glycol and propylene glycol; glycol ethers such as ethylene glycol dimethyl ether, diethylene glycol dimethyl ether, and propylene glycol monomethyl ether acetate; esters such as ethyl acetate, ethyl lactate, and γ-butyrolactone; phenols such as phenol and chlorophenol; amides such as N,N-dimethylformamide, N,N-dimethylacetamide, and N-methylpyrrolidone; halogen-containing solvents such as chloroform, methylene chloride, tetrachloroethane, monochlorobenzene, and dichlorobenzene; hetero-element containing compounds such as carbon disulfide; water; and mixture solvents thereof. Especially, ethanol and isopropyl alcohol are preferable. Further, a mixture of water and ethanol and a mixture of water and isopropyl alcohol are also preferable.

As an additive of the sol-gel material, it is possible to use polyethylene glycol, polyethylene oxide, hydroxypropylcellulose, and polyvinyl alcohol for viscosity adjustment; alkanolamine such as triethanolamine, β-diketone such as acetylacetone, β-ketoester, formamid, dimetylformamide, dioxane, and the like, as a solution stabilizer.

Note that it is allowable to use a photo-curable sol-gel material, other than using the sol-gel material which is cured by being heated. In such a case, it is possible to adopt, for example, a method in which photo-acid generator such as hexafluorophosphate aromatic sulfonium salt which generates acid by light is used, or a method in which chemical modification (chelation) is caused by adding β-diketone represented by acetylacetone to a sol and the chemical modification is removed by being irradiated with light.

### <Coating step>

The substrate is coated with the sol-gel material prepared as described above (step S3 of Fig. 1). As the substrate, substrates made of inorganic materials such as glass, silica glass, and silicon substrates or substrates of resins such as polyethylene terephthalate (PET), polyethylene naphthalate (PEN), polycarbonate (PC), cycloolefin polymer (COP), polymethyl methacrylate (PMMA), polystyrene (PS), polyimide (PI), and polyarylate may be used. The substrate may be transparent or opaque. If a substrate having the concave-convex pattern obtained by using this substrate is used for production of the organic EL element as will be described later, this substrate desirably has the heat resistance, the light resistance against ultraviolet (UV) light, and the like. In these respects, substrates made of inorganic materials such as glass, silica glass, and silicon substrates are more preferable. It is allowable to perform a surface treatment or provide an easy-adhesion layer on the substrate in order to improve an adhesion property, and to provide a gas barrier layer in order to keep out moisture and/or gas such as oxygen. As the coating method, it is possible to use any coating method including, for example, a bar coating method, a spin coating method, a spray coating method, a dip coating method, a die coating method, and an ink-jet method. The die coating method, the bar coating method, and the spin coating method are preferable, because the substrate having a relatively large area can be coated uniformly with the so-gel material and the coating can be quickly completed prior to curing (gelation) of the sol-gel material. It is noted that, since a sol-gel material layer with a desired concave-convex pattern is formed in subsequent steps, the surface of the substrate (including the surface on which the surface treatment has been performed or the easy-adhesion layer if the surface treatment has been performed or the easy-adhesion layer has been formed) may be flat, and the substrate itself does not have the desired concave-convex pattern.

### <Transfer step>

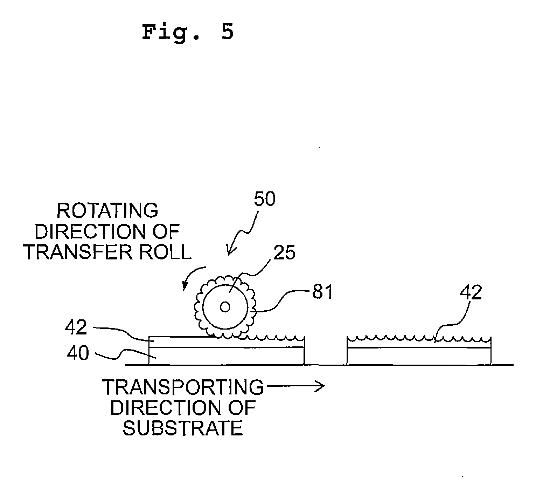

After the coating step, the pattern of the gas-permeable member 81 is transferred to a coating film 42 by using the roll apparatus 300 depicted in Figs. 3 and 4 (step S4 of Fig. 1). An exemplary transfer method will be explained with reference to Fig. 5. In order to simplify the drawing, Fig. 5 only depicts the transfer roll 50 of the roll apparatus 300. As depicted in Fig. 5, the transfer roll 50 and a substrate 40 are disposed so that the substrate 40 is positioned immediately below the transfer roll 50 in a state of being brought into contact the transfer roll 50. The substrate 40 is transported or conveyed relative to the transfer roll 50. The rotation of the transfer roll 50 synchronized with the transport of the substrate 40 allows the substrate 40 to advance or travel in a transporting direction with the gas-permeable member 81 adhered to (brought in tight contact with) the coating film 42. Here, the solvent in the coating film 42 and water generated by the condensation reaction of the sol-gel material can diffuse in the gas-permeable member 81 even during the time in which the gas-permeable member 81 is adhered to the coating film 42. This helps the evaporation of water and the solvent in the coating film 42 to promote the curing of the coating film 42. Further, since the suction roll 25 of the transfer roll 50 has the suction function, the gas or object on the outer circumferential surface 25a of the suction roll 25 can be sucked or absorbed toward the inside of the suction roll 25 via a large number of suction holes 69 of the outer circumferential surface 25a of the suction roll 25. This promotes the diffusion of water and the solvent in the coating film 42 into the gas-permeable member 81. Thus, the evaporation of water and the solvent in the coating film 42 proceeds further to promote the curing of the coating film 42. Since the coating film 42 is subjected to the suction force of the transfer roll 50, the coating film 42 fits in the concave-convex pattern of the gas-permeable member 81 without any space therebetween. This enables the faithful transfer of concave-convex pattern of the gas-permeable member 81 to the coating film 42, thereby making it possible prevent any transfer failure.

When the gas-permeable member 81 of the transfer roll 50 is adhered to the coating film 42, the coating film 42 may be heated. Heating promotes the chemical reaction in the coating film 42 and the evaporation of the solvent and water generated by the chemical reaction, thereby facilitating the curing of the coating film 42. The heating of the coating film 42 may be performed, for example, through or via the transfer roll 50, from the side of the substrate 40, or directly. When the heating through the transfer roll 50 is performed, a heating means may be provided in the transfer roll 50, and any heating means can be used. Although it is preferred that a heater be included in the transfer roll 50, the heater may be provided separately from the transfer roll 50. Any transfer roll 50 may be used, provided that the coating film 42 can be brought in contact with the gas-permeable member 81 while heated. The heating temperature of the coating film 42 may be in a range of 40 to 150 degrees Celsius. When the coating film 42 is heated by use of the transfer roll 50, the heating temperature of the transfer roll 50 may be also in a range of 40 to 150 degrees Celsius. When the heating temperature of the coating film 42 or the transfer roll 50 exceeds 150 degrees Celsius, the heating temperature is liable to exceed the heatresistant temperature of the gas-permeable member 81 made of rubber material. When the photo-curable sol-gel material is used for the coating film 42, the coating film 42 may turn into a gel (be cured) by being irradiated with light instead of the heating of the coating film 42.

Such a roll process has the following advantages over a pressing system: i) the roll process has high productivity; ii) the roll process can prevent the generation of bubbles of gas in the pattern which would be otherwise caused by the bumping of solvent in the coating film 42 and/or prevent any traces or marks of gas from being left; iii) adhering pressure and releasing force (peeling force) can be reduced owing to the line contact between the coating film 42 and the mold, thereby making it possible to easily handle a substrate with a large area readily; and iv) no bubble is involved during the transfer. Since the flexible gas-permeable member 81 is used as the mold in the manufacturing method of the present invention, when the concave-convex pattern of the gas-permeable member 81 is adhered to the coating film 42 made of the sol-gel material, on the relatively hard substrate 40, the gas-permeable member 81 can be uniformly brought into contact with the entire surface of the substrate 40. This allows the gas-permeable member 81 to be uniformly adhered to the coating film 42, thereby making it possible to prevent any transfer failure.

One of the advantages of the process, in which the suction roll 25 and the gas-permeable member 81 as the mold are used, is that the transfer failure is less likely to occur as compared with the process in which a roll having no suction mechanism and a mold having no gas permeability are used. The coating film 42 is dried to increase the hardness during the time after the coating film 42 made of the sol-gel material is formed on the substrate 40 before the coating film 42 is adhered to the mold. Thus, the process, in which the roll having no suction mechanism and the mold having no gas permeability are used, requires to precisely control the dry condition of the coating film and to keep the viscosity of coating film constant, in order to transfer the concave-convex pattern of the mold to the coating film faithfully. On the other hand, the process, in which the gas-permeable member 81 and the suction roll 25 are used in accordance with the present invention, has the effect for facilitating the curing of coating film 42 during the time in which the coating film 42 is adhered to the gas-permeable member 81 (mold). Thus, the coating film 42 may be adhered to the gas-permeable member 81 (mold) while being sufficiently soft, and the precise control of the dry condition of the coating film 42 is not required. Since the sufficiently soft coating film 42 is adhered to the gas-permeable member 81, the coating film 42 fits in the concave-convex pattern of the gas-permeable member 81 without any space therebetween. This enables the faithful transfer of the concave-convex pattern of the gas-permeable member 81 to the coating film 42. If air is trapped between the concave-convex pattern and the coating film 42, the trapped air is sucked by the suction roll 25 in the present invention. This prevents a pattern defect which would be otherwise caused by the trapped air. Further, the gas-permeable member 81 used in the production method of the prevent invention is elastic, and thus the gas-permeable member 81 as the mold is less likely to be damaged or broken, even when the gas-permeable member 81 is subjected to friction and/or deformed during the transfer.

The gas-permeable member 81 of the transfer roll 50 is released from the coating film 42 to which the concave-convex pattern of the gas-permeable member 81 has been transferred. The mold used in this embodiment is in a roll shape, and thus the rotation of the transfer roll 50 causes the gas-permeable member 81 to be automatically released from the coating film 42 immediately after the transfer of the concave-convex pattern. The releasing force may be smaller particularly than that in a case of using a plate-shaped mold. The mold can be easily released from the coating film 42 without allowing any portions of the coating film 42 to be remained on the mold.

### <Baking step (curing step)>

After the gas-permeable member 81 is released from the coating film (sol-gel material layer) 42 on the substrate, the coating film 42 is subjected to baking (step S5 of Fig. 1). The hydroxyl group or the like contained in the coating film 42 is desorbed or eliminated by the baking to further harden (solidify) the coating film 42. It is preferred that the baking be performed at temperatures of 200 degrees Celsius to 1200 degrees Celsius for about 5 minutes to about 6 hours. Accordingly, the coating film 42 is cured to thereby obtain a structure (diffraction grating) with the concave-convex pattern film corresponding to the concave-convex pattern of the gas-permeable member 81, that is, a structure (diffraction grating) in which the sol-gel material layer (coating film) 42 having the irregular concave-convex pattern is directly formed on the flat substrate. In this situation, the coating film (sol-gel material layer) 42 is amorphous, crystalline, or in a mixture state of the amorphous and the crystalline, depending on the baking temperature and the baking time. When the photo-curable sol-gel material is used for the coating film 42, the coating film 42 may be cured by being irradiated with light instead of being subjected to baking. Further, a hydrophobization treatment may be performed on each of the above surfaces. The hydrophobization treatment may be performed by any known method. For example, when the hydrophobization treatment is performed on the surface made of silica, it is allowable to use a method in which the hydrophobization treatment is performed, for example, with dimethyl dichlorosilane or trimethyl alkoxysilane; it is allowable to use a method in which the hydrophobization treatment is performed with silicone oil and trimethyl silylating agent such as hexamethyldisilazane; or it is allowable to use a surface treatment method for metal oxide powder by use of supercritical carbon dioxide.

### <Manufacturing apparatus for optical substrate>

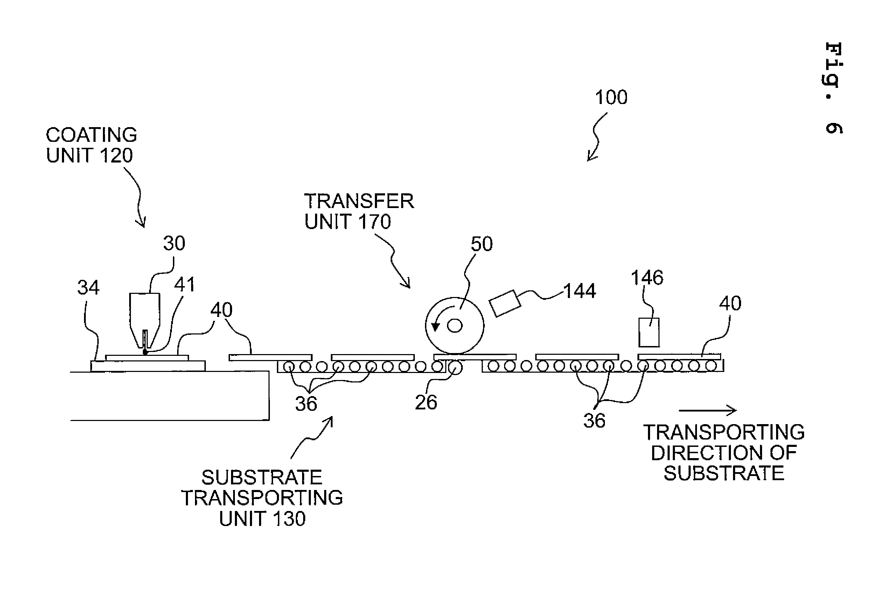

In order to perform the method for manufacturing the optical substrate of the above embodiment, it is possible to use, for example, an optical-substrate manufacturing apparatus 100 for manufacturing the optical substrate, as depicted in Fig. 6. The optical-substrate manufacturing apparatus 100 mainly includes a coating unit (coating-film forming unit) 120 for coating the substrate 40 with the sol-gel material 41; a substrate transporting unit 130 for transporting the substrate 40; and a transfer unit 170 for transferring the pattern of the gas-permeable member 81 to the sol-gel material on the substrate 40.

The coating unit 120 includes a substrate stage 34 which is movable while holding the substrate 40 and a die coater 30 which is positioned above the substrate stage 34 and coats the substrate 40 with the sol-gel material 41 (applies the sol-gel material 41 on the substrate 40). The substrate transporting unit 130 includes rotating rolls 36 aligned in the transporting direction of the substrate 40 (from the left side to the right side in Fig. 6) and transports the substrate 40 placed on the rotating rolls 36 in the transporting direction by driving and rotating the rotating rolls.

The transfer unit 170 is provided at a predetermined position on the transport path of the substrate 40. The transfer unit 170 mainly includes the transfer roll 50. As the transfer roll 50, it is possible to use the roll having the structure explained by use of Figs. 3 and 4.

In the transfer unit 170, the transfer roll 50 sucks the coating film (not depicted in Fig. 6) made of the sol-gel material and formed on the substrate 40 while the gas-permeable member 81 is brought into contact with the coating film. The transfer unit 170 may include a supporting roll 26 which faces the transfer roll 50 with the substrate 40 intervening therebetween. The supporting roll 26 is rotationally driven to feed the substrate 40 to the downstream side in the substrate transporting direction. The supporting roll 26 may include a heater. It is possible to use any other driving means such as a movable table which moves while supporting the substrate, instead of using the supporting roll 26. A heating furnace (heater) may be provided instead of the supporting roll 26. It is possible to use, for example, an infrared heater, hot-air heating, and a hot plate as the heating furnace.

The optical substrate manufacturing apparatus 100 may further include an electricity-removing unit 146 for removing electricity from the substrate 40 to which the concave-convex pattern of the gas-permeable member 81 has been transferred. The electricity-removing unit 146 may be disposed on the downstream side of the transfer unit 170.

The optical-substrate manufacturing apparatus 100 may include a control unit (not depicted) which comprehensively controls the operation of the entire apparatus and respective operations of the coating unit 120, the transfer unit 170, and the substrate transporting unit 130. The control unit controls driving speeds of the substrate transporting unit 130 and the transfer unit 170 so that the substrate 40 transported by the substrate transporting unit 130 is transported in synchronization with the transfer roll 50 of the transfer unit 170 when passing through the transfer unit 170. Further, the optical-substrate apparatus 100 may include an inspection device for observing the thickness and state of the coating film formed by the coating unit 120, an inspection device for observing the concave-convex pattern of the coating film after the concave-convex pattern of the gas-permeable member 81 is transferred, and the like.

An explanation will be given about the operation for processing the substrate 40 by use of the optical-substrate manufacturing apparatus 100. In the coating unit 120, the substrate 40 is coated uniformly with the sol-gel material 41 by applying the sol-gel material 41 on the substrate 40 by using the die coater 30 while the substrate stage 34 holding the substrate 40 is moved in the transporting direction. Subsequently, the substrate 40 on which the coating film made of the sol-gel material 41 is formed is transported onto the rotating rolls 36 disposed on the upstream side of the transfer unit 170, and then the substrate 40 is transported to the transfer unit 170. In the transfer unit 170, the gas-permeable member 81 put around the suction roll 25 of the transfer roll 50 is placed on the coating film of the substrate 40 and adhered thereto while the transfer roll 50 is being rotated and the suction force (sucking force) is being generated by means of the suction roll 25. The coating film is cured in a state that the gas-permeable member 81 is adhered to the coating film formed on the substrate 40, and thus the concave-convex pattern of the gas-permeable member 81 is transferred to the coating film (sol-gel material) on the substrate 40. When the substrate 40 passes the transfer unit 170, the gas-permeable member 81 of the transfer roll 50 is released from the coating film. The electricity-removing unit 144 removes electricity from the gas-permeable member 81 released from the coating film. The electricity-removing unit 146 removes electricity from the substrate 40 from which the gas-permeable member 81 is released. Then, the substrate 40 goes out of the optical-substrate manufacturing apparatus 100. Accordingly, it is obtained the substrate 40 with the coating film to which the concave-convex pattern of the gas-permeable member 81 has been transferred. After that, the substrate 40 with the pattern is subjected to the baking in an oven (not depicted) or the like. The oven for baking may be provided in the apparatus 100.

In the transfer unit 170, the solvent in the coating film and water generated by the chemical reaction in the coating film diffuse in the gas-permeable member 81 while the gas-permeable member 81 is being adhered to the coating film formed on the substrate 40. Further, the suction of the coating film by means of the transfer roll 50 helps the diffusion of the solvent and water into the gas-permeable member 81. This further promotes the curing of coating film. The transfer roll 50 may be heated to temperatures of 40 to 150 degrees Celsius. The heating facilitates the chemical reaction in the coating film and the evaporation of the solvent and water generated by the chemical reaction, thereby proceeding the curing (gelation) of the coating film.

An explanation will be made about modified embodiments of the optical-substrate manufacturing apparatus of the above embodiment.

### <Modified embodiments>

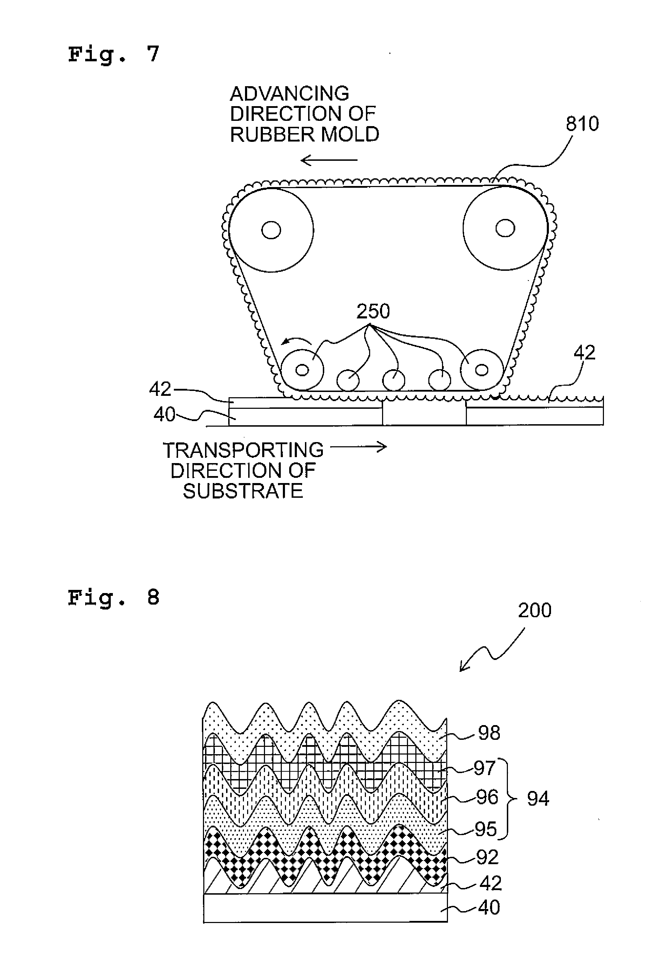

The transfer roll 50, which is formed of the gas-permeable member 81 and the suction roll 25, which has the outer circumferential surface 25a around which the gas-permeable member 81 is put, is used in the optical-substrate manufacturing apparatus 100 of the above embodiment. Instead of using the transfer roll 50, a ring-like or looped gas-permeable member 810 may be disposed to be stretched between of wound around two or more of rolls 250, which include at least one suction roll as depicted in Fig. 7. In this modified embodiment, the gas-permeable member 810 is adhered to the coating film 42 on the substrate 40 by means of the roll disposed on the most upstream side, and the gas-permeable member 810 is released from the coating film 42 by means of the roll disposed on the most downstream side. Accordingly, a state in which the gas-permeable member 810 is adhered to the coating film 42 can be maintained by a distance between the most upstream roll and the most downstream roll in the substrate transporting direction (for a certain period of time).

In this modified embodiment, all or any of the most upstream roll, the most downstream roll, and the rolls disposed therebetween is/are the suction roll(s), and the suction roll(s) is/are partially covered with the gas-permeable member 810. This allows the coating film 42 on the substrate 40 to be sucked through suction holes of the gas-permeable member 810. Thus, the evaporation of water and the solvent in the coating film 42 is promoted to facilitate the curing of the coating film 42. In the present invention, "gas-permeable member covering the outer circumferential surface of the suction roll" is a concept further including a case, where the gas-permeable member covers a part of the outer circumferential surface of the suction roll, as in this modified embodiment. The coating film 42 may be heated while the gas-permeable member 810 is adhered to the coating film 42. The heating facilitates the chemical reaction in the coating film 42 and the evaporation of the solvent and water generated by the chemical reaction, thereby promoting the curing (gelation) of the coating film 42. The heating of the coating film 42 may be performed by, for example, using (a) heating roll(s) as all or any of the most upstream roll, the most downstream roll, and the rolls disposed therebetween.

The substrate, in (on) which the pattern made of the sol-gel material layer is formed through the roll process as described above, can be used as, for example, a diffraction-grating substrate for organic EL element, a wire grid polarizer, an antireflection film, or an optical element for providing the light confinement effect in a solar cell by being placed on the photoelectric conversion surface side of the solar cell. Alternatively, the pattern may be transferred to yet another resin by using the above-described substrate having the pattern as a mold (mother die). In this case, the transferred resin pattern is an inverted pattern of the pattern on the substrate. Thus, it is allowable to produce a mold as a replica of the substrate by transferring the transferred inverted pattern to yet another resin. Each of the molds can be subjected to an electroforming process using Ni and the like to form a metal mold. Using each of the molds enables more efficient mass production of an optical component such as the diffraction-grating substrate for organic EL element.

### <Method for producing organic EL element>

An explanation will be given about an example of a method for producing an organic EL element by using a substrate having a pattern made of a sol-gel material layer formed thereon, which is obtained through the roll process as described above, with reference to Fig. 8. At first, the substrate having the pattern made of the sol-gel material layer formed thereon is cleaned with a brush, in order to remove any foreign matter adhered to the substrate, and then an organic matter, etc. is removed with an alkaline cleaning agent and an organic solvent. Next, as depicted in Fig. 8, a transparent electrode 92 is stacked on the sol-gel material layer 42 on the substrate 40 so as to maintain the concave-convex structure formed on the surface of the sol-gel material layer 42. Examples of those usable as the material for the transparent electrode 92 include indium oxide, zinc oxide, tin oxide, indium-tin oxide (ITO) which is a composite material thereof; gold; platinum, silver; copper, etc. Among these materials, ITO is preferable from the viewpoint of the transparency and the electrical conductivity. The thickness of the transparent electrode 92 is preferably within a range of 20 nm to 500 nm. When the thickness is less than the lower limit, the electrical conductivity is more likely to be insufficient. When the thickness exceeds the upper limit, there is possibility that the transparency is so insufficient that the emitted EL light cannot be extracted to the outside sufficiently. As the method for stacking the transparent electrode 92, it is possible to appropriately use any known method such as the evaporation method, sputtering method, spin coating method, etc. Among these methods, the sputtering method is preferably employed from the viewpoint of improving the adhesion property. Afterwards, the transparent electrode 92 is coated with photoresist, followed by being exposed with an electrode mask pattern. Then, etching is performed with a developing solution, thereby obtaining a transparent electrode having a predetermined pattern. Note that during the sputtering, the substrate is exposed to a high temperature of about 300 degrees Celsius. After cleaning the obtained transparent electrode with a brush and removing any organic matter, etc., with an alkaline cleaning agent and an organic solvent, a UV ozone treatment is preferably performed.

Next, an organic layer 94 as depicted in Fig. 8 is stacked on the transparent electrode 92. The organic layer 94 is not particularly limited, provided that the organic layer 94 is one usable as an organic layer of the organic EL element. As the organic layer 94, any known organic layer can be used as appropriate. Further, the organic layer 94 may be a stacked body of various organic thin films, and may be, for example, a stacked body of a hole transporting layer 95, a light emitting layer 96, and an electron transporting layer 97 as depicted in Fig. 8. Here, examples of the material of the hole transporting layer 95 include aromatic diamine compounds such as phthalocyanine derivatives, naphthalocyanine derivatives, porphyrin derivatives, N,N'-bis(3-methylphenyl)-(1,1'-biphenyl)-4,4'-diamine (TPD), and 4,4'-bis[N-(naphthyl)-N-phenyl-amino]biphenyl(α-NPD); oxazole; oxadiazole; triazole; imidazole; imidazolone; stilbene derivatives; pyrazoline derivatives; tetrahydroimidazole; polyarylalkane; butadiene; and 4,4',4"-tris(N-(3-methylphenyl)N-phenylamino) triphenylamine (m-MTDATA). The material of the hole transporting layer 95, however, is not limited to these.

Further, the light emitting layer 96 is provided so that a hole injected from the transparent electrode 92 and an electron injected from a metal electrode 98 are recombined to emit light. Examples of the material usable as the light emitting layer 96 include: metallo-organic complex such as anthracene, naphthalene, pyrene, tetracene, coronene, perylene, phthaloperylene, naphthaloperylene, diphenylbutadiene, tetraphenylbutadiene, coumarin, oxadiazole, bisbenzoxazoline, bisstyryl, cyclopentadiene, and aluminum-quinolinol complex (Alq3); tri-(p-terphenyl-4-yl)amine; 1-aryl-2,5-di(2-thienyl) pyrrole derivatives; pyran; quinacridone; rubren; distyylbenzene derivatives; distyryl arylene derivatives; distyryl amine derivatives; and various fluorescent pigments or dyes. Furthermore, it is preferable that light-emitting materials selected from the above compounds are mixed as appropriate and then are used. Moreover, it is possible to suitably use a material system generating emission of light from a spin multiplet, such as a phosphorescence emitting material generating emission of phosphorescence, and a compound including, in a part of the molecules, a constituent portion formed by the above materials. Note that the phosphorescence emitting material preferably includes heavy metal such as iridium. A host material having high carrier mobility may be doped with each of the light-emitting materials as a guest material to generate the light emission using the dipole-dipole interaction (Foerster mechanism) or electron exchange interaction (Dexter mechanism). Examples of the material of the electron transporting layer 97 include heterocyclic tetracarboxylic anhydrides such as nitro-substituted fluorene derivatives, diphenylquinone derivatives, thiopyran dioxide derivatives, and naphthaleneperylene; and organometallic complex such as carbodiimide, fluorenylidene methane derivatives, anthraquino dimethane and anthrone derivatives, oxadiazole derivatives, and aluminum-quinolinol complex (Alq3). Further, in the above-described oxadiazole derivatives, it is also possible to use, as an electron transporting material, thiadiazole derivatives in which oxygen atoms of oxadiazole rings are substituted by sulfur atoms and quinoxaline derivatives having quinoxaline rings known as electron attractive group. Furthermore, it is also possible to use a polymeric material in which the above materials are introduced into a macromolecular chain or the above materials are made to be a main chain of the macromolecular chain. Note that the hole transporting layer 95 or the electron transporting layer 97 may also function as the light-emitting layer 96. In this case, the organic layer between the transparent electrode 92 and the metal electrode 98 is double-layered.

From the viewpoint of facilitating the electron injection from the metal electrode 98, a layer made of a metal fluoride or metal oxide such as lithium fluoride (LiF) or Li₂O₃, a highly active alkaline earth metal such as Ca, Ba, or Cs, an organic insulating material, or the like may be provided as an electron injection layer between the organic layer 94 and the metal electrode 98. Further, from the viewpoint of facilitating the hole injection from the transparent electrode 92, it is allowable to provide, as a hole injection layer between the organic layer 94 and the transparent electrode 92, a layer made of triazol derivatives, oxadiazole derivative, imidazole derivative, polyarylalkane derivatives, pyrazoline and pyrazolone derivatives, phenylenediamine derivative, arylamine derivatives, amino-substituted calcone derivatives, oxazole derivatives, styrylanthracene derivatives, fluorenone derivatives, hydrazone derivatives, stilbene derivatives, silazane derivatives, aniline-based copolymers, or electroconductive high-molecular oligomar, particularly thiophene oligomer.

Furthermore, when the organic layer 94 is a stacked body formed of the hole transporting layer 95, the light emitting layer 96 and the electron transporting layer 97, the thicknesses of the hole transporting layer 95, the light emitting layer 96 and the electron transporting layer 97 are preferably within a range of 1 nm to 200 nm, a range of 5 nm to 100 nm, and a range of 5 nm to 200 nm, respectively. As the method for stacking the organic layer 94, any known method such as the vapor deposition method, sputtering method, spin coating method and die coating method can be employed as appropriate.

In the step for forming the organic EL element, subsequently, the metal electrode 98 is stacked on the organic layer 94, as depicted in Fig. 8. Materials of the metal electrode 98 are not particularly limited, and a substance having a small work function can be used as appropriate. Examples of the materials include aluminum, MgAg, MgIn, and AlLi. The thickness of the metal electrode 98 is preferably within a range of 50 nm to 500 nm. When the thickness is less than the lower limit, the electrical conductivity is more likely to be decreased. When the thickness exceeds the upper limit, there is such a possibility that the repair might be difficult to perform when any short circuit occurs between the electrodes. Any known method such as the vapor deposition method, sputtering method, etc. can be adopted to stack the metal electrode 98. Accordingly, an organic EL element 200 having a structure as depicted in Fig. 8 can be obtained.

As described above, since the concave-convex pattern of the optical substrate produced in accordance with the method of present invention is made of the metal oxide such as the sol-gel material, this optical substrate is advantageous in the following points as compared with a substrate having a concave-convex pattern made of a curable resin. Namely, since the sol-gel material has excellent mechanical strength, any flaw or scratch, adhesion of any foreign matter, generation of any projected portion on the transparent electrode during the production process of the organic EL element are less likely to occur, even when the cleaning with a brush is performed for the surface formed with the concave-convex pattern after the formation of the substrate and the transparent electrode, thereby making it possible to prevent any failure of the element which would be otherwise caused by the flaw, foreign matter, projected portion, etc. Therefore, the organic EL element obtained by the method of the present invention is more superior to that obtained by using the substrate made of the curable resin, in view of the mechanical strength of the substrate having the concave-convex pattern.

The substrate, which is produced in accordance with the method of the present invention by use of the metal oxide such as the sol-gel material, has excellent chemical resistance, and thus has a relatively high corrosion resistance against the alkaline solution, the organic solvent, etc. used in the cleaning step of the substrate and the transparent electrode, thereby making it possible to use a variety of kinds of cleaning solutions. Further, the alkaline developing solution is used during the patterning of the transparent substrate in some cases as described above, and the substrate formed of the sol-gel material has also chemical resistance against such a developing solution. In this respect, the substrate formed by use of the metal oxide such as sol-gel material is advantageous as compared with the substrate formed by use of the curable resin of which chemical resistance to the alkaline solution is relatively low.

The substrate, which is produced in accordance with the method of the present invention by use of the metal oxide such as the sol-gel material, has excellent heat resistance. Therefore, the substrate formed by use of the metal oxide such as sol-gel material can withstand a high temperature environment of the sputtering step in the process of forming the transparent electrode for the organic EL element. Further, the substrate formed of the sol-gel material produced in accordance with the method of the present invention has UV resistance and weather resistance superior to those of the substrate made of the curable resin, and thus also has the resistance against the UV ozone cleaning treatment performed after the formation of transparent electrode.

When the organic EL element produced by the method of the present invention is used outdoors, any degradation due to the sunlight can be prevented more than when an organic EL element produced by using the substrate having the concave-convex pattern formed in the curable resin is used. Further, any long term use of the organic EL element using the resin substrate is difficult because the curable resin as described above might be degraded to generate any yellowing, any gas, etc. when the curable resin is left under a high temperature environment for a long period of time due to the heat generation associated with the light emission. In contrast, such degradation is prevented in the organic EL element provided with the substrate made of the sol-gel material.

Although the present invention has been explained as above with the embodiment, the roll apparatus and the method for producing the member having the concave-convex structure, such as the optical substrate having the concave-convex pattern, in accordance with the present invention, are not limited to the above-described embodiment, and may be appropriately modified or changed within the range of the technical ideas described in the following claims. The use of the roll apparatus of the present invention is not limited to the production of the optical substrate, and the roll apparatus can be used for various uses including, for example, the production of optical elements such as microlens arrays, nanoprism arrays, and optical waveguides; the production of optical components such as lenses; the production of LED; the production of solar cells; the production of antireflection films; the production of semiconductor chips; the production of patterned media; the production of data storage; the production of electronic paper; the production of LSI; paper manufacturing; food manufacturing; and the biology field such as immunoassay chips and cell culture sheets. The gas-permeable member may have a flat surface structure without any concave-convex pattern. In this case, the gas-permeable member can be used for such a use that water and/or gas in an object to be processed such as the coating film is/are sucked through the gas-permeable member by the aid of the suction roll while the object to be processed is pressed against the gas-permeable member. It is possible to use various materials as the material of the coating film depending on the way of use. For example, in cases of producing optical elements, optical components, solar cells, antireflection films, semiconductor chips, patterned media, data storage, electronic paper, LSI, and the like, it is possible to use photoreactive (photocurable) resins, thermoreactive (thermosetting) resins, polymeric resins, metal oxides such as the sol-gel material, organic-inorganic hybrid materials, etc. Further, fibrous materials, particulate (spherical) materials, and flaky or flake-like materials can be added to the above materials. The material to be added is exemplified, for example, by organic compounds (including low-molecular compounds and high-molecular compounds), inorganic compounds (including carbon materials, silicon materials, metals, metal oxides, and the like), and organic-inorganic hybrid materials. The material to be added is not limited to those. Further, pulp and the like can be used as the coating material in the paper manufacturing, and a variety of food materials can be used as the coating material in the food manufacturing.

### Industrial Applicability

The roll apparatus and the method for producing the member having the concave-convex structure in accordance with the present invention are capable of producing the member having the concave-convex structure with high throughput while performing the minute pattern transfer accurately and reliably. The concave-convex pattern of the member having the concave-convex structure produced by the roll apparatus and the production method in accordance with the present invention is excellent in the heat resistance, weather resistance, and corrosion resistance. Further, the concave-convex pattern is also resistant to the process for manufacturing an element (device) in which the member having the concave-convex structure is incorporated, which makes it possible to extend the service life of the element. Therefore, the member having the concave-convex structure obtained by the production method and the production apparatus of the present invention is quite effective for various devices such as the organic EL elements and the solar cells. By using, as the optical substrate, the member having concave-convex structure obtained in this manner, the various devices, such as the organic EL elements and the solar cells, which are excellent in the heat resistance, weather resistance and corrosion resistance, can be produced. Further, the use of the roll apparatus of the present invention is not limited to the production of the optical substrate, and the roll apparatus can be used in various uses. For example, the roll apparatus of the present invention can be used, for example, for the production of light condensing or focusing films and antireflection films for solar cells and various displays; the production of semiconductor chips and the like; paper manufacturing such as the production of tissues (for example, drums used for compressing webs); food manufacturing such as noodle making; and the production in the biologic field such as bio chips including fine or minute channels, bio chips for analyzing genome and proteome, cell culture sheets (nanopillar sheets used as cell culture containers), and microchips for cell fractionation or cell separation.

### Reference Signs List:

25: suction roll; 26: supporting roll; 30: die coater; 34: substrate stage; 36: rotating roll; 38: master mold; 40: substrate; 41: sol-gel material; 42: coating film (sol-gel material layer); 50: transfer roll; 63: support base; 65: suction mechanism; 67: drive unit; 69: suction hole; 81: gas-permeable member; 92: transparent electrode; 94: organic layer; 95: hole transporting layer; 96: light-emitting layer; 97: electron transporting layer; 98: metal electrode; 100: optical-substrate manufacturing apparatus; 144, 146: electricity-removing unit; 120: coating unit; 130: substrate transporting unit; 170: transfer unit; 200: organic EL element; 300: roll apparatus

## Claims

1. A roll apparatus, comprising:
a suction roll being rotatable and having an outer circumferential surface and an inside defined by the outer circumferential surface;
a suction mechanism configured to generate a suction force toward the inside from an outside of the suction roll; and
a gas-permeable member covering the outer circumference surface of the suction roll.

2. The roll apparatus according to claim 1, wherein the gas-permeable member is made of silicone rubber.

3. The roll apparatus according to claim 1 or 2, wherein a concave-convex pattern is formed on a surface of the gas-permeable member.

4. The roll apparatus according to claim 3, wherein the concave-convex pattern of the gas-permeable member is a pattern by which a sol-gel material is patterned.

5. The roll apparatus according to claim 3 or 4, wherein the concave-convex pattern of the gas-permeable member is an irregular concave-convex pattern in which a standard deviation of depth of concavities and convexities is in a range of 10 nm to 100 nm and an average pitch of the concavities and convexities is in a range of 100 nm to 1500 nm.

6. The roll apparatus according to any one of claims 3 to 5, wherein a Fourier-transformed image of the concave-convex pattern of the gas-permeable member shows an annular pattern.

7. The roll apparatus according to any one of claims 1 to 6, further comprising a heating means configured to heat the suction roll.

8. The roll apparatus according to any one of claims 1 to 7, wherein the gas-permeable member has a water vapor transmission rate of not less than 1 x 10⁻⁶ [(mL·cm) / (cm²·s·cmHg)].

9. The roll apparatus according to any one of claims 1 to 8, wherein the gas-permeable member has a thickness ranging from 10 µm to 1 cm.

10. The roll apparatus according to any one of claims 1 to 9, wherein the gas-permeable member has surface energy of not more than 25 mN/m.

11. The roll apparatus according to any one of claims 1 to 10, further comprising a driving unit configured to rotate the suction roll around a rotational shaft thereof.

12. The roll apparatus according to any one of claims 1 to 11, wherein the outer circumferential surface of the suction roll is made of a porous body.

13. The roll apparatus according to claim 12, wherein the porous body is ceramic.

14. The roll apparatus according to any one of claims 1 to 11, wherein the outer circumferential surface of the suction roll has a mesh-like form in which suction holes are provided uniformly at a regular interval.

15. A method for producing a member having a concave-convex structure by use of the roll apparatus as defined in any one of claims 3 to 14, the method comprising:
a step of forming a coating film on a substrate;
a step of transferring the concave-convex pattern of the gas-permeable member onto the coating film by adhering the concave-convex pattern of the gas-permeable member to the coating film while rotating the suction roll; and
a step of curing the coating film.

16. The method for producing the member having the concave-convex structure according to claim 15, wherein the concave-convex pattern is transferred to the coating film while the suction force is being generated in the suction roll.

17. The method for producing the member having the concave-convex structure according to claim 15 or 16, wherein the coating film is made of a sol-gel material.

18. The method for producing the member having the concave-convex structure according to any one of claims 15 to 17, wherein the coating film is adhered to the concave-convex pattern of the gas-permeable member while being heated.

19. The method for producing the member having the concave-convex structure according to any one of claims 15 to 18, wherein the member having the concave-convex structure is an optical substrate.

20. A method for producing an organic EL element, comprising:
preparing a diffraction grating substrate having a concave-convex surface as the member having the concave-convex structure, by the method for producing the member having the concave-convex structure as defined in any one of claims 15 to 19, the diffraction grating substrate being prepared; and
successively stacking a transparent electrode, an organic layer, and a metal electrode on the concave-convex surface of the diffraction grating substrate.
